# EUROPEAN PATENT SPECIFICATION

(11) **EP 0 592 746 B1**
(45) Date of publication and mention of the grant of the patent: **19.03.1997**
(21) Application number: 92810786.1
(22) Date of filing: 14.10.1992
(51) Int. Cl.: H01S 3/025, H01L 33/00, G02B 6/42

(54) **Encapsulated light emitting diode and method for encapsulating the same**
Gekapselte, lichtemittierende Diode und Kapselungsverfahren
Diode électroluminescente encapsulée et méthode d'encapsulation

(43) Date of publication of application: 20.04.1994
(73) Proprietor: International Business Machines Corporation, Armonk, N.Y. 10504 (US)
(72) Inventor: Broom, Ronald F., Dr., CH-8002 Zürich (CH)
(74) Representative: Heusch, Christian

(56) References cited:
- EP-A- 0 039 017
- EP-A- 0 374 121
- EP-A- 0 466 975
- PATENT ABSTRACTS OF JAPAN vol. 9, no. 126 (E-318)31 May 1985;& JP-A-6012782
- PATENT ABSTRACTS OF JAPAN vol. 12, no. 389 (E-669)17 October 1988;& JP-A-63131586
- PATENT ABSTRACTS OF JAPAN vol. 13, no. 51 (E-712)6 February 1989;& JP-A-63244781
- PATENT ABSTRACTS OF JAPAN vol. 6, no. 21 (E-93)6 February 1982;& JP-A-56142657
- PATENT ABSTRACTS OF JAPAN vol. 10, no. 69 (E-389)18 March 1986;& JP-A-60217687

## Description

### TECHNICAL FIELD

The invention describes a means for hermetically sealing light emitting diodes, in particular laser diodes, to yield protection from the environment and to simplify packaging.

### BACKGROUND OF THE INVENTION

Semiconductor light emitting diodes, being very sensitive against moisture, exposure to chemicals such as detergents, and mechanical stress and strain, have to be encapsulated, in and protected by, an appropriate housing. Additionally, the housing should allow electrical as well as optical interconnections.

Encapsulation and packaging of these diodes should be simple and cheap on one hand and as reliable and durable as possible on the other hand. Different means for encapsulation of conventional semiconductor devices are known in the art, most of them not being suited for application to light emitting diodes, or being mechanically complex. However, some proposals are known, reducing the complexity of the housing as such and employing epoxy-like materials for hermetically sealing a diode.

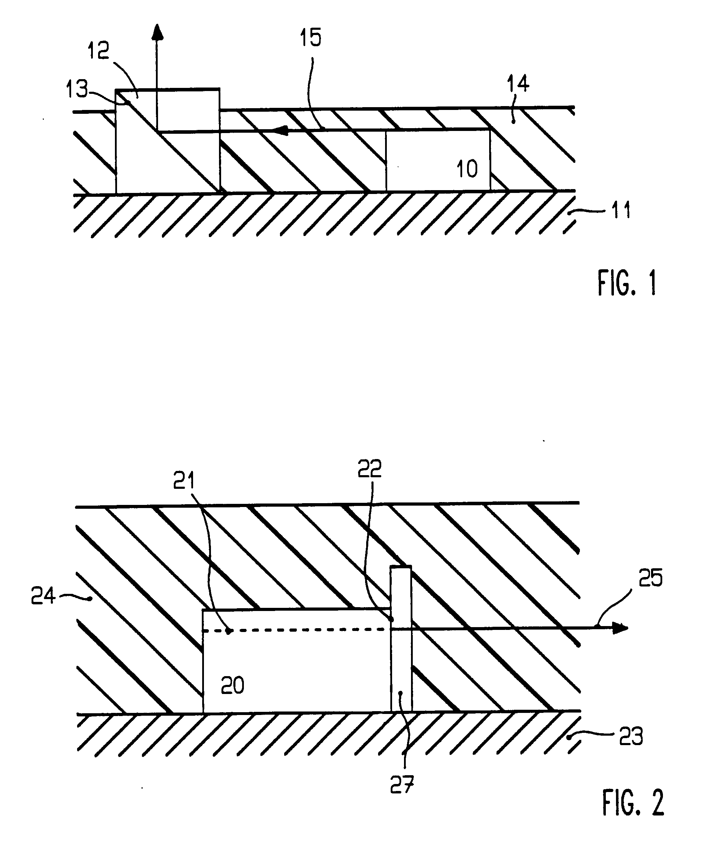

One example, out of a wide variety of similar proposals, is given in European Patent application, EP-A 0 466 975, with title "Semiconductor Light-Emitting Device". The principle of the light emitting device's encapsulation is schematically illustrated in Figure 1. As can be seen in this Figure, an edge emitting laser diode 10 is mounted on a mounting base 11. In a certain distance to this diode 10, a cube 12 with 45 ° mirror facet 13 is situated, providing for an optical output port. The laser diode 10 and the already mentioned cube 12 are sealed and held in a transparent resin 14. This resin 14 adheres to the laser's facets and fills the space between the laser 10 and the cube 12. The upper surface of the cube 12 is not covered by the resin 14. As indicated by arrow 15, a light beam emitted from the laser 10 propagates through the resin 14, prior to being reflected out of the resin 14.

The Patent Abstract of Japan, Vol. 9, No. 126 (E-318), 31 May 1985 and the corresponding patent JP-A-60 12 782 concerns a structure which allows coupling of a fiber to a diode. For this reason a photo penetration hole is provided in a lead frame such that the light emitting diode can optically access the fiber through the hole in the lead frame via a sealing transparent resin. There remains a 'gap' of a certain thickness between said diode and the sealing resin.

In European Patent application with publication number EP-A 374 121 a light emitting diode is described which is situated in a depression of a mounting base. A resin is poured over this diode to fix it at the mounting base. The whole structure is covered by a housing and there exists a hollow space between the light emitting portion of said diode and the housing. There is a hollow space delimited by the housing made of plastic.

The Patent Abstract of Japan, Vol. 13, No. 51, (E-712), 6 February 1989, and the corresponding patent JP-A-63 244 781 concerns a diode which is fixed at a metallic stem floor. This stem floor has an opening and the diode is placed right above this opening. A ball lens is placed in this opening and a space is left between the diode and the lens. There is no hermetically sealed gap disclosed which is totally enclosed by an encapsulant.

The Patent Abstract of Japan, Vol. 6, No. 21, (E-93), 6 February 1982, and the corresponding patent JP-A-56 142 657 relates to a device which is bonded to a depression of a metallic pickup terminal. There is no encapsulant used to fix the device at this terminal. The whole depression is filled with a silicon oil. The device, surrounded by this resin oil, is sealed in an insulator.

A critical element of a light emitting diode is the light emitting facet, referred to as mirror facets when addressing laser diodes. Because of the small emitting area, depending on the design of a light emitting diode, the optical flux density can become very high ( > 1 MW/cm²) and consequently corrosion or contamination can easily lead to degradation of the output or melting of the light emitting facet through thermal runaway. Organic encapsulants, such as the transparent resin employed in Figure 1, all have very low thermal conductivity so that only a small degree of absorption can result in a high local temperature rise. For this reason, most of the laser diodes are hermetically sealed in metal enclosures which ensure that only an inert gas is in contact with the sensitive facets. An important disadvantage of hermetically sealing light emitting diodes using an encapsulant, as for example shown in Figure 1, is that the encapsulant adheres to the light emitting facet thus directly interacting with it and causing thermal problems if light beams with high optical flux density are generated. Furthermore, chemical changes in the encapsulant, caused by the high optical flux, can accelerate degradation (corrosion) of the facet.

### OBJECTS OF THE INVENTION

It is an object of the present invention to provide for a hermetic encapsulation of light emitting diodes which overcomes the disadvantages of known encapsulations.

It is another object of the present invention to provide for a simple, reliable and low cost encapsulation technique.

### SUMMARY OF THE INVENTION

This has been accomplished by providing for an 'air' gap, or a region having an inert gas or a vacuum in direct contact with the light emitting facet of a light emitting diode, the remaining portions of the diode being sealed in an encapsulant. The invention is defined in independent device claim 1 and in independent method claim 8. Embodiments are set out in the dependent claims.

### DESCRIPTION OF THE DRAWINGS

The invention is described in detail below with reference to the following drawings, which are schematic and not drawn to scale, while more particularly the dimensions of some parts are exaggerated for the sake of clarity.
- **FIG. 1**: shows a schematic cross-section of an edge emitting laser diode and an optical output port sealed in a transparent resin, as known in the art.
- **FIG. 2**: shows a schematic cross-section of an edge emitting laser diode encapsulated with the provision of an 'air' gap in front of the mirror facet, according to the first embodiment of the present invention.
- **FIG. 3**: shows steps of the encapsulation of an edge emitting laser diode, in accordance with the first embodiment of the present invention:
**A** bonding the laser diode to a mounting base and placing a thin foil in front of the mirror;
**B** sealing the laser diode, the thin foil serving as a dam;
**C** removing the foil and covering the whole structure with an encapsulant.
- **FIG. 4**: shows steps of the encapsulation of an edge emitting laser diode and an optical fiber, in accordance with the second embodiment of the present invention:
**A** bonding the laser diode to a mounting base and placing an optical fiber in a groove;
**B** placing a thin foil in front of the mirror of the laser diode and pushing the fiber against it;
**C** removing the foil and covering the whole structure with an encapsulant to seal the structure.
- **FIG. 5**: shows steps of the encapsulation of an edge emitting laser diode and an optical lens, in accordance with the third embodiment of the present invention:
**A** mounting the laser diode on a mounting base;
**B** placing a thin foil in front of the mirror of the laser, covering the structure with a sealing cap and inserting a lens;
**C** turning the whole structure and partially filling it with an encapsulant;
**D** removing the foil and filling the sealing cap up with an encapsulant.

### GENERAL DESCRIPTION

Before describing different embodiments of the present invention, some different materials to be employed as encapsulants are described separately. These materials, which have to be transparent when being situated in the light path and in addition should be durable and easy to handle, are well known in the art. Typical materials are cyclic alipathic epoxy resins, diglycidyl esters, polyurethans, and polymethyl methacrylates (PMMA), to name some of them. Different diglycidyl esters are described in the European Patent EP-B 0 039 017, with title "Verfahren zur Herstellung transparenter Giessharze". Additional information is available from manufactures of optical resins or their distributors. A listing of some resins is for example given in a leaflet, published by Polyscience AG, Bleichistrasse 8, CH-6300 Zug/Switzerland, titled "UV-aushärtende Epoxies, Klebstoffe und Abdeckmassen". Said Polyscience AG is a distributor of products of the Electro-Lite Corporation, Danbury, CT, U.S.A..

A first embodiment of the present invention is described in Figure 2. In this Figure, a schematic cross-section through a module comprising an edge emitting laser diode 20, its active layer being indicated by dashed line 21, situated on, and bonded to, a mounting base 23 is illustrated. The whole laser diode 20 is encapsulated by a transparent resin 24 providing for a narrow 'air' gap 27 in front of, and in direct contact to, the laser's mirror 22. The width of said 'air' gap is typically less than 1000 µm., and preferably between 5 µm and 100 µm. The hermetically sealed gap 27 ensures an environment of optimum conditions being decoupled from the surrounding environment. The laser mirror 22 is not exposed to mechanical stress/strain or chemicals, after being encapsulated. Further packaging of this diode, being encapsulated in accordance with the present invention, can be done by employing conventional metal housings with window, as f.e. given in US Patent US-A 5 052 009, with title "Semiconductor Laser Device and Process of Assembling the Same".

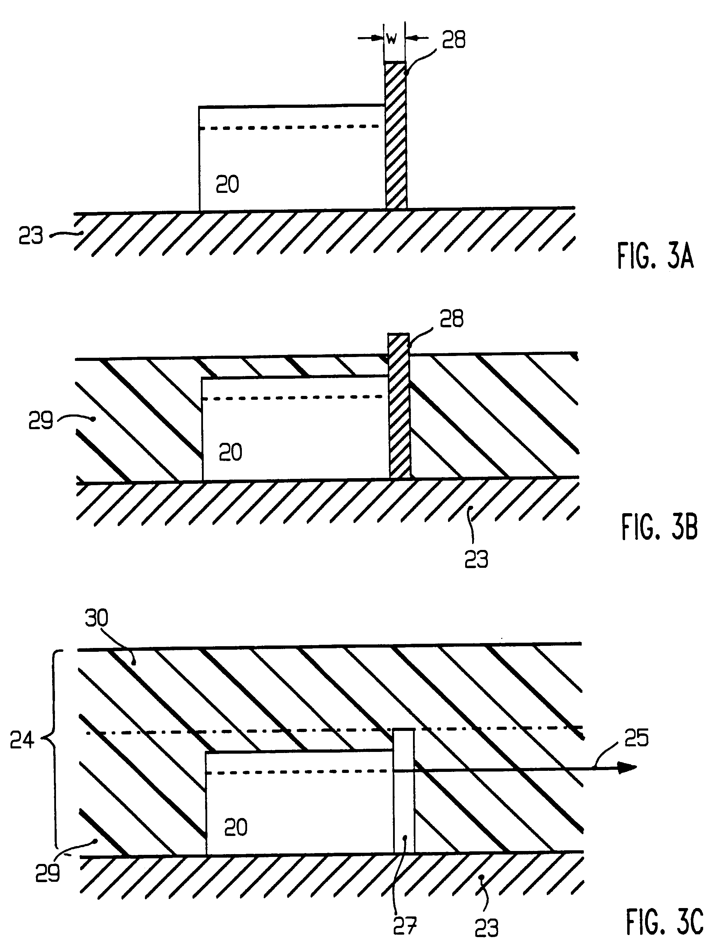

The first embodiment of the method for encapsulating the laser diode 20 is explained in context with Figures 3A - 3C, which show intermediate steps of the encapsulation. As shown in Figure 3A, a laser diode 20 is mounted junction-side-up, also referred to as epi-side-up, on top of a mounting base 23. The laser diode 20 may be bonded to this mounting base 23, f.e.. A thin foil 28, of well defined thickness w, is placed and fixed in front of the mirror facet of the laser 20. This foil 28 has to be held in place during the next step by means of clamps for example. Next, the laser diode 20 and the foil 28 are sealed in a first encapsulant 29. This encapsulant 29 should be transparent for the particular wavelength emitted by the laser, such that a light beam emitted can pass through the encapsulant 29 nearly un-attenuated. As shown in Figure 3B, the upper portion of the foil 28 remains uncovered, the foil serving as kind of a dam. Prior to finally encapsulating the whole structure, the foil 28 has to be removed after the first encapsulant has hardened. This can either be done by etching it, solving it in a suitable solvent, or by mechanically removing it. After removal of the foil 28, a narrow gap 27 is left in direct contact to the mirror, the width of the gap 27 being defined by the foil's thickness w. To complete the encapsulation, a further layer of an encapsulant 30 is laid over the structure covering up the gap 27, as shown in Figure 3C. The trapped air or inert gas, e.g. nitrogen, in the gap 27 prevents ingress of this additional layer 30. Choosing an encapsulant of high viscosity and a narrow width of the gap, the whole process can be carried out in a vacuum environment, such that there is a vacuum in said gap 27. Rapid application and accelerated hardening, e.g. by employment of bin UV-light source, ensures that the encapsulant is not drawn into the gap.

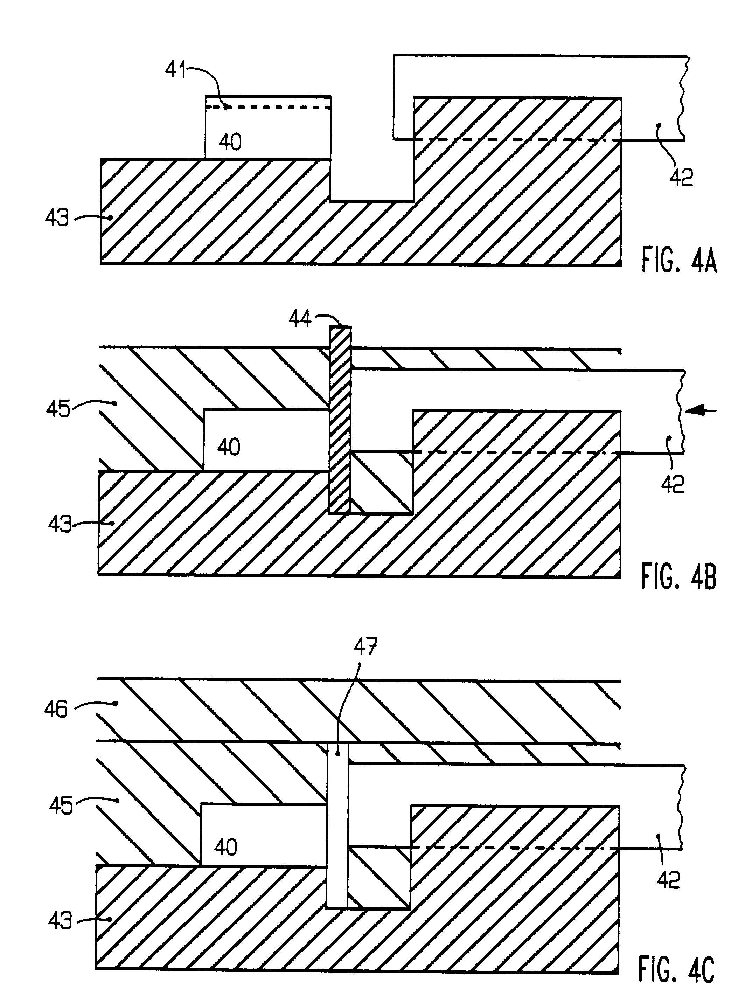

By the means described in context with the first embodiment, the laser is completely sealed but no epoxy or other encapsulant comes in contact with the laser mirror. However, in this particular embodiment, an encapsulant is present in the optical light path. As can be seen in Figures 4A - 4C, there are other embodiments of the method of the present invention, eliminating the encapsulant from the optical path.

The second embodiment of the method of the present invention, described in connection with Figures 4A - 4C, concerns an edge emitting laser diode 40 being coupled to an optical fiber 42 serving as optical output port. As illustrated in Figure 4A, said laser 40 is mounted junction-side-up, the dashed line representing the active layer 41, on top of a structured mounting base 43. This mounting base 43 is structured such that it provides for a mounting area to which said laser 40 can be bonded, an alignment support for the fiber 42, which either is part of said mounting base 43 or attached to it. A recess may be situated between the laser's mounting area and the alignment support, if necessary. Said alignment support is shaped such that the fiber has only one degree of freedom, i.e. perpendicular to the plane of the laser mirror. This can be achieved by provision of a v-shaped groove in said alignment support, as known from articles such as "Self-Adjusted Permanent Attachment of Fibers to GaAs Waveguide Components", H. Kaufmann et al., Electronics Letters, Vol. 22, No. 12, June 1986, pp. 642 - 643.

Next, a thin foil 44 is placed between the mirror and the fiber 42, with the latter being used to clamp the foil 44 gently against the surface of the mirror by pushing the fiber 42 towards the laser 40, as indicated by the arrow on the right hand side of Figure 4B. Similar to the first step of encapsulation, described in context with the first embodiment, an encapsulant 45 is flowed over the laser 40 and fiber 42 with the foil 44 acting as a dam. This intermediate step is schematically shown in Figure 4B. After this encapsulant 45 has hardened, the foil 44 is removed using suitable means as already described. A narrow gap 47 is left between the laser mirror and the fiber 42 - of width defined by the foil thickness. The encapsulation is completed by application of a further encapsulation layer 46. As can be seen in Figure 4C, the complete laser is covered, no encapsulant remaining in the optical path. Efficient optical coupling is ensured by this technique. The alignment between the fiber 42 and the laser 40 is highly reproducible and precise.

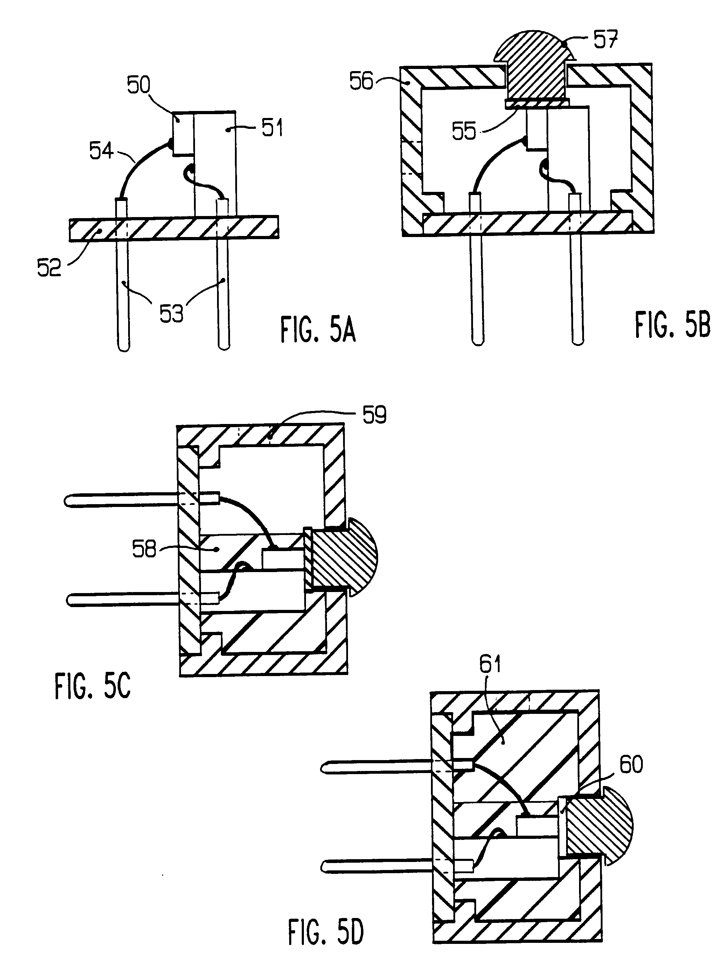

The third embodiment of the method of the present invention is pointed out in connection with Figures 5A through 5D. As can be seen from these Figures, the complete packaging of a laser diode 50 will be described. Prior to starting with the encapsulation of laser diode 50, it has to be bonded to a substrate 51. This substrate 51 is fixed at, or connected to, a base plate 52 with metal pins 53. The upper ends of these metal pins 53 are connected by means of connecting wires 54 to the laser's contact metallizations, not shown in the Figures. Next, a thin soluble foil 55 is placed on top of the front mirror of the laser 50 such that it covers at least the light emitting portion thereof. A cylindrical sealing cap 56, preferably made of metal, which has a window in its upper portion is situated on top of the baseplate 52. An optical lens 57, e.g. being shaped like a mushroom, is inserted from outside of the sealing cap in said window, the size of said window and said lens being chosen such that the lens 57 can be moved up and down. By pressing the lens 57 against the foil 55, it is clamped in place. As shown in Figure 5C, the whole structure will now be turned 90 °. Similar to the steps already described in context with the first and second embodiment, an encapsulant 58 is now flowed over the laser 50, mounted on the substrate 51, the foil 55, and the lens 57. This liquid encapsulant is poured into the inner portion of the sealing cap 56 via an opening 59, f.e.. After this encapsulant 58 has hardened, either the sealing cap 56 is removed to bring the foil 55 in contact with a suitable solvent, or this solvent is directly filled into the sealing cap using opening 59. After this step, a narrow gap is left between the laser mirror and the lens 57. The remaining portion of the sealing cap 56, back in its original position, is now filled up with an encapsulant 61. It should be ensured that the gap 60 is not filled with this encapsulant 61.

It should be obvious, that the different embodiments described above can be modified without deviating from the scope of the invention as claimed. Some exemplary modifications are mentioned below:
- various kinds of light emitting diodes, such as surface emitting diodes, arrays of laser diodes and so forth, can be encapsulated in accordance with the present invention;
- The shape, size, thickness, and material of the foil, to be placed in front of the light emitting facet in accordance with the method of the invention, can be chosen to be well suited for the respective environment;
- the light emitting diode can either be mounted epi-side-up or -down, which ever allows better packaging and cooling;
- the mounting base and fiber alignment support of the method of the invention can be modified if necessary;
- conventional baseplates and sealing caps. as well as specially designed ones, can be employed;
- Multi mode fibers, single mode fibers, fiber arrays, rod lenses, focusing or spreading lenses, simple plane windows or other optical means, such as beam splitters can be coupled to, and encapsulated with, a light emitting diode, in accordance with the method of the present invention.

By the above described means, light emitting diodes are completely sealed, but no encapsulant comes in contact with their light emitting facets. To summarize, the described packaging technique makes possible the use of a wide variety of different encapsulants. The resultant reduction in complexity and cost on one hand, combined with increased device lifetime and improved reliability, extends the range of applications of these devices.

## Claims

1. Optical module comprising a semiconductor light emitting diode (20) mounted on a mounting base (23), and an encapsulant (24) holding said diode (20) in place, characterized in that said encapsulant in addition provides for a gap (27) in front of the light emitting portion of said diode's (20) light emitting facet, said gap (27) being completely enclosed in and hermetically sealed by said encapsulant (24), a defined gaseous atmosphere, or a vacuum, being established in said gap (27) such that at least said light emitting portion is placed in said defined gaseous atmosphere, or vacuum.

2. The optical module of claim 1, characterized in that said light emitting diode is a laser diode (20), the light emitting facet (22) thereof being one of the facets defining the cavity of the laser (20).

3. The optical module of claim 1, or 2, characterized in that said gap (27) has a width between 5 µm and 100 µm.

4. The optical module of claim 1 or 2, characterized in that said encapsulant (24) comprises cyclic alipathic epoxy resin, diglycidyl ester, polyurethan, or polymethyl methacrylate (PMMA).

5. The optical module of claim 1 or 2, characterized in that vacuum conditions are established in said gap (27).

6. The optical module of claim 1 or 2, characterized in that said gap (27) is filled with an inert gas, such as nitrogen.

7. The optical module of claim 1 or 2, characterized in that said gap (27) is filled with air.

8. Method for the encapsulation of a semiconductor light emitting diode (20; 40; 50), comprising the steps of:
a) mounting said diode (20; 40; 50) on a mounting base (23; 43; 51),
b) placing a thin foil (28; 44; 55) in front of the light emitting facet of said diode (20; 40; 50), said foil (28; 44; 55) covering at least the light emitting portion of said light emitting facet,
c) flowing a first encapsulant (29; 45; 58) over the diode (20; 40; 50) with the foil (28; 44; 55) acting as dam;
d) removing said foil (28; 44; 55) after said first encapsulant (29; 45; 58) has hardened, leaving a gap (27; 47; 60) in direct contact with the light emitting portion of said light emitting facet,
e) completing the encapsulation by flowing a second encapsulant (30; 46; 61) over said structure such that the second encapsulant (30; 46; 61) covers the opening of the gap (27; 47; 60) but is not drawn into it.

9. Method of claim 8, characterized in that said foil (28; 44; 55) is a soluble foil, said foil (28; 44; 55) being removed by employment of a suitable solvent.

10. Method of claim 8, characterized in that an optical fiber (42) is placed in an alignment support and pressed against said foil (44) prior to step c), the fiber (42) serving as clamp.

11. Method of claim 8, characterized in that said first encapsulant (29; 45; 58) and/or second encapsulant (30; 46; 61) comprise(s) cyclic alipathic epoxy resin, diglycidyl ester, polyurethan, or polymethyl methacrylate (PMMA).

12. Method of claim 9, characterized in that step e) is carried out in a well defined gaseous environment such as an inert gas atmosphere, e.g. nitrogen, or in a vacuum.

13. Method of claim 9, characterized in that step e) is carried out in air.

## Patentansprüche

1. Optisches Modul mit einer lichtemittierenden Halbleiterdiode (20), die auf einer Montagebasis (23) angebracht ist, und einem Einkapselungsmittel (24), das die Diode (20) in Position hält, dadurch gekennzeichnet, daß das Einkapselungsmittel außerdem für einen Spalt (27) vor dem lichtemittierenden Bereich der lichtemittierenden Facette (20) der Diode sorgt, wobei der Spalt (27) vollständig in dem Einkapselungsmittel (24) eingeschlossen und durch dieses hermetisch abgedichtet ist, wobei eine definierte gasförmige Atmosphäre oder ein Vakuum in dem Spalt (27) bereitgestellt ist, so daß wenigstens der lichtemittierende Bereich in der definierten gasförmigen Atmosphäre oder dem Vakuum plaziert ist.

2. Optisches Modul nach Anspruch 1, dadurch gekennzeichnet, daß die lichtemittierende Diode eine Laserdiode (20) ist, wobei deren lichtemittierende Facette (22) eine der Kristallflächen ist, die den Resonanzraum des Lasers (20) definieren.

3. Optisches Modul nach Anspruch 1 oder 2, dadurch gekennzeichnet, daß der Spalt (27) eine Breite zwischen 5 µm und 100 µm aufweist.

4. Optisches Modul nach Anspruch 1 oder 2, dadurch gekennzeichnet, daß das Einkapselungsmittel (24) cyclisches aliphatisches Epoxyharz, Diglycidylester, Polyurethan oder Polymethylmethacrylat (PMMA) beinhaltet.

5. Optisches Modul nach Anspruch 1 oder 2, dadurch gekennzeichnet, daß in dem Spalt (27) Vakuumbedingungen bereitgestellt sind.

6. Optisches Modul nach Anspruch 1 oder 2, dadurch gekennzeichnet, daß der Spalt (27) mit einem inerten Gas, wie Stickstoff, gefüllt ist.

7. Optisches Modul nach Anspruch 1 oder 2, dadurch gekennzeichnet, daß der Spalt (27) mit Luft gefüllt ist.

8. Verfahren zum Einkapseln einer lichtemittierenden Halbleiterdiode (20; 40; 50), das die Schritte umfaßt:
a) Montieren der Diode (20; 40; 50) auf einer Montagebasis (23; 43; 51),
b) Plazieren einer dünnen Folie (28; 44; 55) vor der lichtemittierenden Facette der Diode (20; 40; 50), wobei die Folie (28; 44; 55) wenigstens den lichtemittierenden Bereich der lichtemittierenden Facette bedeckt,
c) Strömen eines ersten Einkapselungsmittels (29; 45; 58) über die Diode (20; 40; 50), wobei die Folie (28; 44; 55) als Damm wirkt;
d) Entfernen der Folie (28; 44; 55) nach einer Härtung des ersten Einkapselungsmittels (29; 45; 58), wobei ein Spalt (27; 47; 60) in direktem Kontakt mit dem lichtemittierenden Bereich der lichtemittierenden Facette verbleibt,
e) Fertigstellen der Einkapselung dadurch, daß man ein zweites Einkapselungsmittel (30; 46; 61) derart über die Struktur strömen läßt, daß das zweite Einkapselungsmittel (30; 46; 61) die Öffnung des Spalts (27; 47; 60) bedeckt, jedoch nicht in ihn hineingezogen wird.

9. Verfahren nach Anspruch 8, dadurch gekennzeichnet, daß die Folie (28; 44; 55) eine auflösbare Folie ist, wobei die Folie (28; 44; 55) durch Verwendung eines geeigneten Lösungsmittels entfernt wird.

10. Verfahren nach Anspruch 8, dadurch gekennzeichnet, daß vor Schritt (c) eine optische Faser (42) in einem Justierträger angeordnet und gegen die Folie (44) gepreßt wird, wobei die Faser (42) als Klammer dient.

11. Verfahren nach Anspruch 8, dadurch gekennzeichnet, daß das erste Einkapselungsmittel (29; 45; 58) und/oder das zweite Einkapselungsmittel (30; 46; 61) cyclisches aliphatisches Epoxyharz, Diglycidylester, Polyurethan oder Polymethylmethacrylat (PMMA) beinhalten.

12. Verfahren nach Anspruch 9, dadurch gekennzeichnet, daß Schritt e) in einer gut definierten gasförmigen Umgebung, wie einer inerten Gasatmosphäre, z.B. Stickstoff, oder in einem Vakuum ausgeführt wird.

13. Verfahren nach Anspruch 9, dadurch gekennzeichnet, daß Schritt e) an Luft ausgeführt wird.

## Revendications

1. Module optique comprenant une diode électroluminescente à semiconducteur (20) montée sur une base de montage (23) et un agent d'enrobage (24) maintenant ladite diode (20) en place, caractérisé en ce que ledit agent d'enrobage, procure en outre un interstice (27) devant la partie d'émission de lumière de la facette d'émission de lumière de ladite diode (20), ledit interstice (27) étant complètement enfermé et scellé hermétiquement par ledit agent d'enrobage (24), une atmosphère gazeuse définie, ou du vide, étant établi dans ledit interstice (27) de sorte qu'au moins ladite partie d'émission de lumière soit placée dans ladite atmosphère gazeuse définie, ou le vide.

2. Module optique selon la revendication 1, caractérisé en ce que ladite diode électroluminescente est une diode à laser (20), la facette émettant de la lumière (22) de celle-ci étant l'une des facettes définissant la cavité du laser (20).

3. Module optique selon la revendication 1, ou 2, caractérisé en ce que ledit interstice (27) présente une largeur entre 5 µm et 100 µm.

4. Module optique selon la revendication 1 ou 2, caractérisé en ce que ledit agent d'enrobage (24) est constitué de résine époxy aliphatique cyclique, d'ester diglycidile, de polyuréthanne, ou de polyméthacrylate de méthyle (PMMA).

5. Module optique selon la revendication 1 ou 2, caractérisé en ce que des conditions de vide sont établies dans ledit interstice (27).

6. Module optique selon la revendication 1 ou 2, caractérisé en ce que ledit interstice (27) est rempli d'un gaz inerte, tel que de l'azote.

7. Module optique selon la revendication 1 ou 2, caractérisé en ce que ledit interstice (27) est rempli d'air.

8. Procédé d'enrobage d'une diode électroluminescente à semiconducteurs (20, 40, 50), comprenant les étapes consistant à :
a) monter ladite diode (20, 40, 50) sur une base de montage (23, 43, 51),
b) placer une fine feuille (28, 44, 55) devant la facette d'émission de lumière de ladite diode (20, 40, 50), ladite feuille (28, 44, 55) recouvrant au moins la partie d'émission de lumière de ladite facette émettant de la lumière,
c) faire s'écouler un premier agent d'enrobage (29, 45, 58) sur la diode (20, 40, 50), la feuille (28, 44, 55) agissant comme un barrage,
d) enlever ladite feuille (28, 44, 55) après que ledit premier agent d'enrobage (29, 45, 58) ait durci, laisser un interstice (27, 47, 60) en contact direct avec la partie d'émission de lumière de ladite facette émettant de la lumière,
e) achever l'enrobage en faisant s'écouler un second agent d'enrobage (30, 46, 61) sur ladite structure de sorte que le second agent d'enrobage (30, 46, 61) recouvre l'ouverture de l'interstice (27, 47, 60), mais ne soit pas attiré dans celui-ci.

9. Procédé selon la revendication 8, caractérisé en ce que ladite feuille (28, 44, 55) est une feuille soluble, ladite feuille (28, 44, 55) étant enlevée en utilisant un solvant approprié.

10. Procédé selon la revendication 8, caractérisé en ce qu'une fibre optique (42) est placée dans un support d'alignement et est appliquée contre ladite feuille (44) avant l'étape c), la fibre (42) servant d'élément de serrage.

11. Procédé selon la revendication 8, caractérisé en ce que ledit premier agent d'enrobage (29, 45, 58) et/ou le second agent d'enrobage (30, 46, 61) est constitué ou sont constitués de résine époxy aliphatique cyclique, d'ester diglycidile, de polyuréthanne, ou de polyméthacrylate de méthyle (PMMA).

12. Procédé selon la revendication 9, caractérisé en ce que l'étape e) est effectuée dans un environnement gazeux bien défini tel qu'une atmosphère de gaz inerte, par exemple de l'azote, ou dans le vide.

13. Procédé selon la revendication 9, caractérisé en ce que l'étape e) est effectuée dans l'air.
